# FASCICULE DE BREVET EUROPEEN

(11) **EP 3 000 131 B1**
(45) Date de publication et mention de la délivrance du brevet: **09.09.2020**
(21) Numéro de dépôt: 14733227.4
(22) Date de dépôt: 22.05.2014
(51) Int. Cl.: H01L 27/142, H01L 51/44, H01L 31/0224

(54) **MONO CELLULE PHOTOVOLTAÏQUE SEMI-TRANSPARENTE EN COUCHES MINCES**
HALBTRANSPARENTE FOTOVOLTAISCHE DÜNNSCHICHTMONOZELLE
SEMI TRANSPARENT THIN-FILM PHOTOVOLTAIC MONO CELL

(30) Priorité: 23.05.2013 FR 1301180; 27.02.2014 FR 1400493
(43) Date de publication de la demande: 30.03.2016
(73) Titulaire: Garmin Switzerland GmbH, 8200 Schaffhausen (CH)
(72) Inventeur: CARDI Philippe Gilbert Frederic, 13850 G RE ASQUE (FR); DE VECCHI Sylvain, 13090 AIX EN PROVENCE (FR)
(74) Mandataire: Bird & Bird LLP
(86) Numéro de dépôt international: PCT/FR2014/000116
(87) Numéro de publication internationale: WO 2014/188092

(56) Documents cités:
- EP-A2- 1 798 778
- EP-A2- 1 798 779
- WO-A1-92/07386
- WO-A1-2008/093933
- US-A- 4 795 500
- US-A1- 2012 192 924
- US-A1- 2013 247 969

## Description

### Domaine technique de l'invention

La présente invention concerne le domaine des dispositifs photovoltaïques semi transparents à base de mono cellules photovoltaïques en couches minces et destinés à la fois à produire de l'électricité et à voir par transparence, une image associée à la cellule photovoltaïque.

### Etat de la technique

Par couche mince ou de faible épaisseur, on entend des couches photovoltaïques de nature quelconque (organique, inorganique), dont l'épaisseur de l'absorbeur est comprise dans une fourchette allant de quelques dizaines de nanomètres (avec des matériaux photovoltaïques organiques) à quelques dizaines de micromètres (avec certains matériaux photovoltaïques inorganiques).
De tels modules commencent à révéler leur utilité dans toute une série d'applications commerciales, notamment dans le domaine des écrans photovoltaïques pour des dispositifs électroniques tels que les téléphones portables, les tablettes tactiles, les écrans d'ordinateurs ou d'autres dispositifs pourvus d'un écran photovoltaïque semi-transparent, à savoir un écran qui laisse transparaître une image pour un observateur placé devant lui, tout en captant à travers des zones actives photovoltaïques opaques une partie de la lumière incidente pour la transformer en énergie électrique destinée à alimenter le dispositif pourvu d'un tel écran.
Comme cela a été décrit dans le brevet US2012/238540, afin d'améliorer aussi bien leurs performances en matière de transparence qu'en matière de rendement de conversion photovoltaïque, de tels écrans sont de préférence, mais pas nécessairement, associés à une optique, par exemple sous la forme d'un réseau de lentilles superposé au système d'affichage de l'image et au module photovoltaïque semi-transparent.
Or un module photovoltaïque en couches minces est généralement composé de plusieurs cellules photovoltaïques mises en série. Un tel module a notamment été décrit dans le document EP0500451-B1. Cette conception de module a l'avantage d'augmenter la tension électrique aux bornes du module et de réduire le courant conduit par les électrodes du module et ainsi de réduire les pertes résistives notamment au niveau de l'électrode transparente située en face avant de la cellule. Mais cette conception connue a également des inconvénients. Ainsi, la mise en série des cellules photovoltaïques se fait par une méthode de gravure des différentes couches qui composent le module photovoltaïque à couches minces. La première gravure, typiquement appelée P1, est celle de l'électrode transparente, également appelée électrode avant, qui est déposée sur le substrat transparent. La deuxième gravure appelée P2 est celle de la couche d'absorbeur photovoltaïque, encore appelée absorbeur, puisqu'elle absorbe les photons incidents. La troisième gravure, appelée P3, est celle de l'électrode métallique, également appelée électrode arrière, et/ou de la couche d'absorbeur photovoltaïque. Cette conception de modules photovoltaïques ne pose pas de problème particulier dans le cadre de leur usage dans des dispositifs pourvus d'écrans grossiers de grande taille. En revanche, dès que la perception de la qualité d'image de l'écran du dispositif doit être parfaite du point de vue de l'observateur, ce qui est le cas par exemple pour les téléphones portables dits intelligents (« smartphones » en terminologie anglo-saxonne), plusieurs inconvénients liés à la conception des modules photovoltaïques semi-transparents connus apparaissent. Le document EP 1798779 A2 décrit une mono cellule photovoltaïque connue dans l'état de l'art.

### Les inconvénients liés aux décalages de gravure :

En vue en plan, par exemple du point de vue d'un observateur placé en face du module, les gravures P1, P2, P3 sont légèrement décalées les unes par rapport aux autres. Du fait de la précision limitée des techniques de gravure et des tolérances prises pour ne pas les superposer, ce décalage peut être plus ou moins important.
Il en résulte que pour chaque mise en série de deux cellules adjacentes, une largeur de matériau photovoltaïque de l'ordre de 0,3 mm devient inactive au niveau do la conversion photovoltaïque, ce qui diminue le rendement de conversion global de l'écran. Par exemple pour des dimensions typiques d'un smartphone (soit environ 40 x 70 = 2800 mm²), la perte de surface active photovoltaïque peut aller de 5% à 10%, soit jusqu'à 280 mm². Cette perte est donc non négligeable et réduit les avantages qu'on peut obtenir par ailleurs en adoptant un écran semi-transparent photovoltaïque.

### Les inconvénients liés à l'ombrage d'une cellule :

Une autre conséquence de la mise en série de cellules photovoltaïques est la sensibilité à l'ombrage d'un module utilisant des cellules ainsi connectées. En effet, si l'une des cellules est sous un éclairage inférieur à celui des autres cellules (dans le cas d'une ombre portée ou ombrage par exemple), la baisse de production électrique de cette cellule sous ombrage va affecter toutes les autres cellules, car le courant électrique va être réduit de la même manière dans toutes les cellules connectées en série. De la même façon, si l'une des cellules est moins performante que les autres à cause de défauts d'homogénéité du dépôt de matière photovoltaïque ou du dopage par exemple, c'est cette cellule déficiente qui va pénaliser les autres et réduire les performances du module photovoltaïque dans sa globalité.

### Les inconvénients liés à la visibilité des lignes de gravure :

La gravure de l'électrode transparente induit un changement local de l'indice optique de la zone qui est traversée par la lumière émise par un écran rétro éclairé. En conséquence, il existe des déviations locales des rayons lumineux qui passent dans cette zone, et l'observateur perçoit la ligne de gravure même si le matériau est lui-même transparent, ce qui crée un effet optique indésirable.
De plus, dans certaines configurations optiques, les zones de gravure présentes sur les zones de matériau photovoltaïque pourront elles aussi être vues. Le changement d'indice entre deux couches successives de l'empilement peut être aussi visible dans chaque zone de gravure, soit en vue directe, soit par réflexion sous certains angles.
Compte tenu de la qualité optique exigée en général par l'industrie des écrans, qui vise des taux de transparence de l'ordre de 90 % ou plus, la visibilité des lignes de gravure dues à la mise en série des cellules photovoltaïques est donc également à éviter.

### Buts de l'invention

L'invention a par conséquent pour objectif général de proposer une structure de mono-cellule photovoltaïque semi-transparente qui soit dépourvue des inconvénients précités, ainsi qu'un procédé de fabrication de ladite mono cellule.
En particulier, l'invention a pour but de proposer une structure de mono cellule photovoltaïque semi-transparente adaptée pour permettre son intégration satisfaisante dans des écrans de dispositifs électroniques, notamment de téléphones portables. Cette structure doit alors résoudre la contradiction entre la qualité de l'image affichée, donc l'exigence d'une transparence élevée à la lumière, de l'ordre de 80-90 %, et celle d'une production électrique supérieure à 2 mW/cm² sous une illumination équivalente à 1 soleil (AM 1.5 G), non affectée par les problèmes d'ombrage.

### Objet de l'invention

Afin d'atteindre les buts fixés, l'objet de l'invention est une mono cellule photovoltaïque, un appareil utilisant une telle mono cellule, et un procédé de fabrication d'une telle mono cellule, tels que définis dans les revendications 1, 22 et 23. En particulier, un premier objet de l'invention est une mono cellule photovoltaïque semi-transparente à la lumière comportant une pluralité de zones actives photovoltaïques séparées par des zones de transparence, tel que défini dans la revendication 1.

Un premier principe de l'invention consiste à remplacer la mise en série de plusieurs cellules photovoltaïques par une mono cellule, pour l'ensemble de la zone active de conversion. On appelle mono cellule photovoltaïque une cellule photovoltaïque unique, comportant des couches minces d'un seul tenant et comportant au moins deux couches électriquement conductrices, à savoir une électrode transparente et une électrode métallique, et une couche intermédiaire semi-conductrice apte à former une diode photovoltaïque. Comme on le verra dans la description détaillée, cette disposition a pour effet de résoudre au moins partiellement les trois problèmes évoqués ci-dessus.

Cependant cette conception à base de mono cellule crée un nouveau problème qui peut être pénalisant au niveau électrique. En effet, la résistance électrique série de l'électrode transparente limite le courant produit par la mono cellule. Afin de résoudre cet effet parasite, l'invention prévoit de faire des reprises de contact arrière, comme cela sera décrit en liaison avec les figures. L'Invention prévoit d'améliorer la collecte de l'énergie électrique produite par la couche d'absorbeur, par l'ajout d'une ligne de collecte, ou grille de collecte, plus conductrice que les matériaux constitutifs de l'électrode transparente habituellement utilisés.
Selon certains modes de réalisation retenus dans le cadre de l'invention, l'électrode transparente est constituée de graphène ou de nanostructures métalliques ou encore d'un oxyde conducteur transparent tel que le SnO₂, l'ITO, l'IZO, l'AZO, le BZO, le GZO ou le ZnO. L'électrode métallique est formée d'un métal tel que l'aluminium (Al), le nickel (Ni), l'or (Au), l'argent (Ag), le cuivre (Cu), le molybdène (Mo), le chrome (Cr), le titane (Ti) ou le palladium (Pd). La couche d'absorbeur est composée d'un ou plusieurs matériaux semi-conducteurs inorganiques et/ou organiques, par exemple à base de silicium amorphe ou microcristallin, de GaAs (arséniure de gallium), de CdTe (tellurure de cadmium), de CIGS (cuivre - indium - gallium - sélénium) ou à base de polymères. Il peut s'agir de jonctions de type p-i-n ou p-n, ou encore d'architectures tandem, c'est-à-dire comportant plusieurs couches de matériaux qui absorbent préférentiellement une partie différente du spectre lumineux. Elles peuvent être conçues pour convertir la lumière visible et/ou la lumière ultraviolette et/ou la lumière infrarouge en électricité. Avantageusement, le choix des matériaux semi-conducteurs est réalisé pour maximiser la capture des photons dans les conditions d'éclairement visées.

Les zones actives photovoltaïques peuvent être de formes quelconques et de dimensions telles que l'œil humain ne les distingue pas. Pour ce faire, la largeur des zones photovoltaïques est de préférence inférieure à 200 micromètres. Dans un mode de réalisation particulier, les zones actives photovoltaïques ou les zones de transparence sont organisées en réseaux de structures géométriques élémentaires, linéaires, circulaires ou polygonales.

De préférence, afin d'assurer un bon degré de transparence à la mono cellule photovoltaïque, celle-ci comporte des zones de transparence aménagées dans les couches de l'absorbeur et de l'électrode métallique, de manière qu'un observateur situé devant le substrat puisse voir une image affichée derrière la cellule photovoltaïque, ces zones de transparence étant configurées pour laisser subsister entre elles des zones actives photovoltaïques. La transparence de la mono cellule photovoltaïque est fonction de la fraction surfacique occupée par les zones actives photovoltaïques opaques. Dans un mode de réalisation avantageux, les zones de transparence sont aménagées dans l'électrode transparente en plus de l'électrode métallique et de la couche d'absorbeur, afin d'augmenter la transmission de la lumière au niveau des zones de transparence, puisqu'en réduisant le nombre d'interfaces, on minimise les phénomènes optiques de réflexions aux interfaces.

De cette façon, à la différence des modules photovoltaïques connus ayant une taille similaire, on n'a pas de mise en série de cellules individuelles de petite taille, typiquement de l'ordre de moins d'un centimètre en largeur. En outre la mono cellule permet d'éviter la plupart des gravures des couches de la cellule photovoltaïque qui seraient finalement visibles et donc préjudiciables à la qualité de vision d'une image associée au module photovoltaïque.

Au contraire la mono cellule selon l'invention forme une zone homogène sensiblement de la taille du module photovoltaïque ou de l'image associée, cette image pouvant être quelconque. Par exemple il peut s'agir d'une image active d'écran retro éclairé comme dans le cas des téléphones mobiles, tablettes tactiles, ou autres dispositifs avec une image rétro éclairée. Mais il peut aussi s'agir d'une image réflective purement passive, comme dans le cas d'une étiquette électronique, d'un écran bi stable (comme dans le cas du papier électronique dit « e-paper » en terminologie anglo-saxonne), ou même d'une simple feuille de papier portant une image imprimée.

La grille de collecte de la mono cellule est électriquement conductrice et préférentiellement métallique pour faciliter la collecte des charges électriques générées dans la couche d'absorbeur et transportées par l'électrode transparente de la mono cellule. Cette grille de collecte permet donc de réduire la résistance électrique de l'électrode transparente, qui limite les performances électriques de la mono cellule.

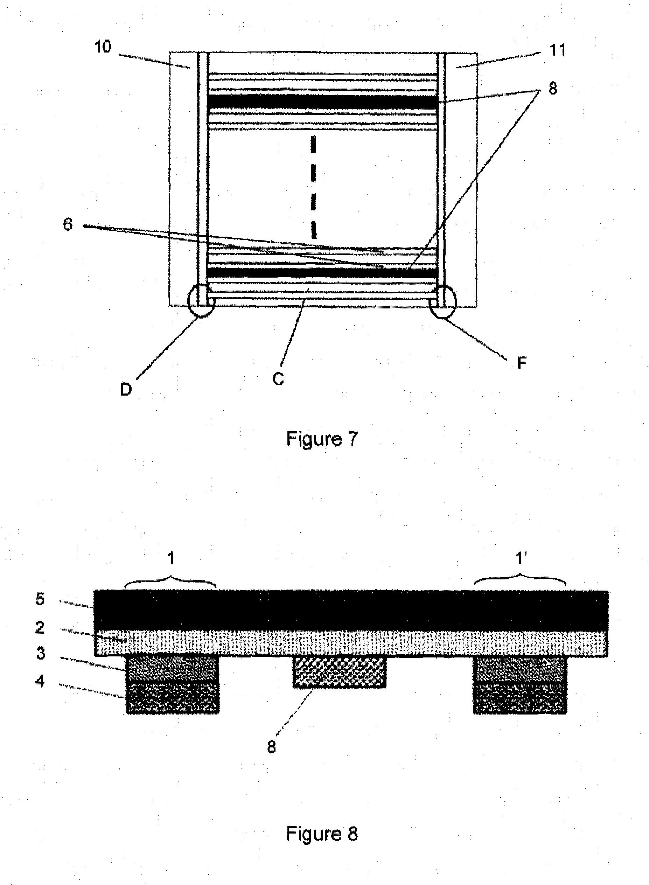

Cette grille de collecte peut être réalisée de multiples façons. Selon un premier mode de réalisation, certaines zones actives photovoltaïques sont substituées par une grille de collecte disposée sur l'électrode transparente entre deux zones actives photovoltaïques adjacentes (cf. figure 8), l'ensemble des grilles de collecte étant reliées électriquement par un bus de collecte.

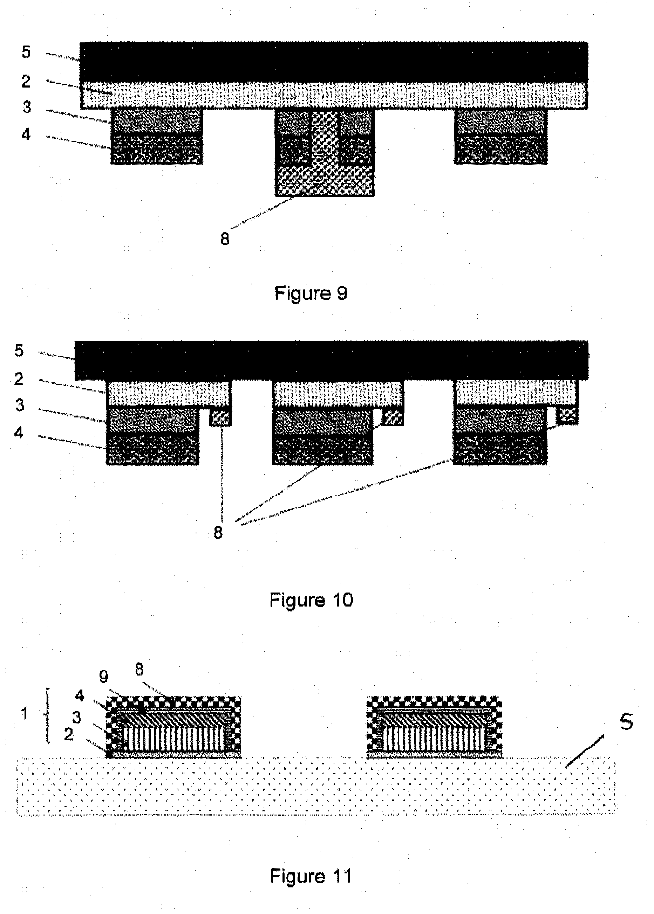

Selon un autre mode de réalisation avantageux, les zones actives photovoltaïques sont constituées de couches d'absorbeur et d'électrodes métalliques moins larges que les électrodes transparentes, et la grille de collecte est constituée de fines bandelettes métalliques disposées sur l'électrode transparente situées au droit de la couche d'absorbeur (cf. figure 10). Ces bandelettes de métal peuvent être très fines et invisibles à l'œil nu, ce qui permet d'augmenter l'homogénéité de l'aspect de la surface de la mono cellule.

Selon une autre variante de réalisation, la grille de collecte est réalisée sous la forme de capots métalliques disposés sur un matériau diélectrique entourant les zones actives photovoltaïques formées d'un empilement de couches minces (cf. figure 11).

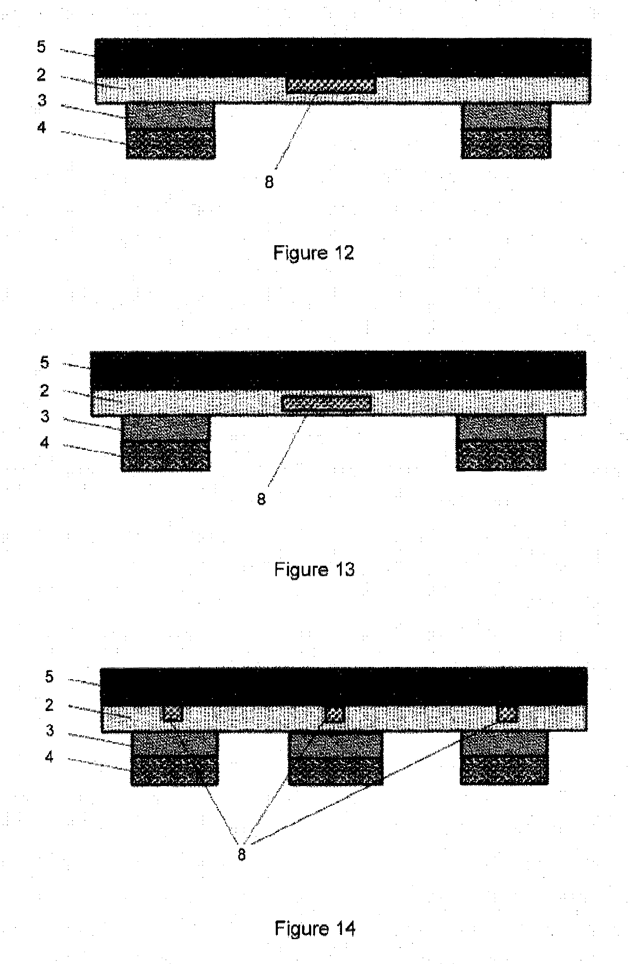

Selon une variante de réalisation supplémentaire, la grille de collecte est disposée sur le substrat avant la réalisation de l'électrode transparente, de sorte que ladite grille de collecte se trouve enterrée dans l'électrode transparente (cf. figure 12). Dans ce cas on peut avoir intérêt à ce que qu'une couche d'antireflet soit interposée entre le substrat et la grille de collecte enterrée, de façon à réduire encore l'impact visuel de la grille de collecte enterrée.

Il est également possible que les zones de la grille de collecte (8) soient disposées complètement à l'intérieur de la couche d'électrode transparente, sous les zones actives photovoltaïques et en retrait par rapport à l'interface avec le substrat (cf. figure 13). Dans ce cas, selon une variante avantageuse, les zones constitutives de la grille de collecte ont une largeur inférieure à la largeur des zones actives photovoltaïques, de sorte que la grille de collecte limite l'ombrage de la lumière ambiante pour maximiser la génération de courant par les zones actives photovoltaïques (cf. figure 14). Par exemple, les zones de la grille de collecte ont une largeur de l'ordre du micromètre et sont situées dans l'électrode transparente sous les zones actives photovoltaïques, de sorte que les bandes de la grille de collecte soient invisibles pour un observateur placé devant le substrat du module.

Alternativement, la grille de collecte est directement à l'intérieur de la couche d'absorbeur.

Avantageusement, pour minimiser l'impact visuel de la grille de collecte, ladite grille de collecte a la forme d'un T renversé disposé sur certaines zones actives photovoltaïques, de façon que seule une petite surface de la grille de collecte correspondant à la base du T renversé n'entre en contact avec l'électrode transparente (cf. figure 9). Cela réduit l'impact visuel de la grille de collecte, mais on perd la surface de zone de collecte correspondante, puisque la zone de production de courant est alors shuntée.

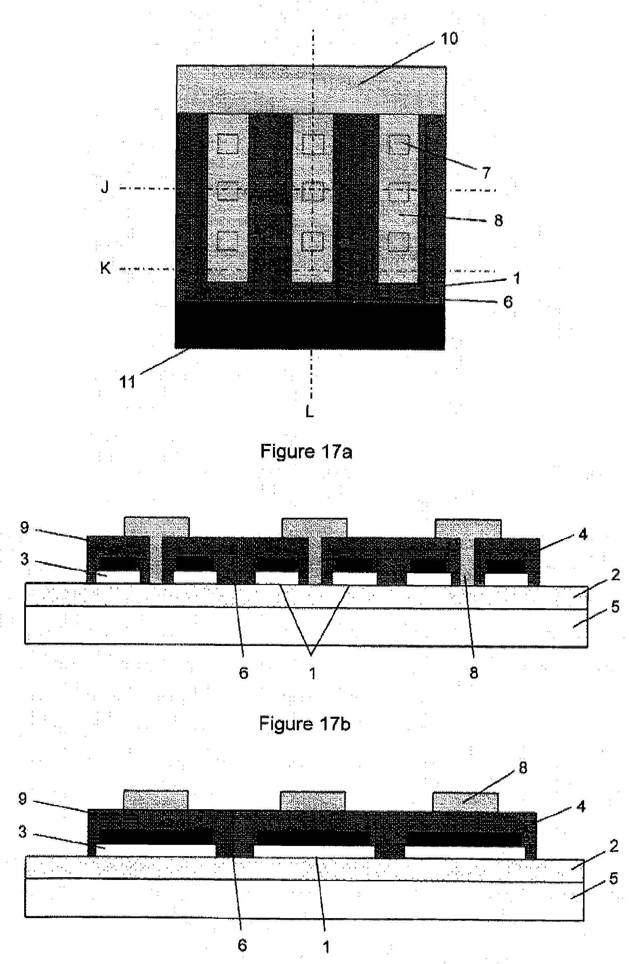

Afin de remédier à cela, il peut être prévu que les zones d'interface entre les bandes métalliques en forme de T renversé et les zones actives photovoltaïques soient passivées à l'aide d'un isolant électrique, la grille de collecte étant alors déposée sur la couche de passivation. On obtient la même réduction de l'impact visuel de la grille de collecte qu'auparavant, mais on garde la zone active photovoltaïque correspondante en état de fonctionner. Dans ce mode de réalisation, lesdites zones actives photovoltaïques contiennent plusieurs canaux, aménagés dans l'électrode métallique et la couche d'absorbeur, au niveau desquels une grille de collecte électriquement conductrice est en contact avec l'électrode transparente, ladite grille de collecte étant séparée de l'électrode métallique et de la couche d'absorbeur par un matériau diélectrique, de manière à réduire la résistance électrique de l'électrode transparente tout en minimisant la visibilité de la grille de collecte (cf. figure 17).

Le nombre de canaux aménagés dans les zones actives photovoltaïques, ainsi que la surface de contact entre la grille de collecte et l'électrode transparente sont ajustés de manière à minimiser la résistance électrique série de la mono cellule tout en réduisant au maximum les effets optiques dus à la présence de cette grille de collecte et indésirables pour l'observateur. L'homme du métier saura adapter la densité des canaux et la taille des grilles de collecte en fonction de la résistance électrique intrinsèque de l'électrode transparente et en fonction du courant électrique que la mono cellule photovoltaïque doit fournir dans l'application visée.

La grille de collecte est séparée de la couche d'absorbeur et de l'électrode métallique qui délimitent les canaux par une couche de matériau diélectrique qui isole électriquement la grille de collecte de ces couches minces, afin de supprimer toute possibilité de court-circuit, ce qui entrainerait une dégradation des performances électriques de la mono cellule.

Les grilles de collecte disposées dans l'ensemble des canaux sont reliées électriquement entre elles par un bus de collecte de la face avant isolé électriquement du bus de collecte de la face arrière qui relie électriquement les électrodes métalliques. L'isolation électrique entre les deux bus peut être réalisée à l'aide du matériau diélectrique précédemment décrit. Par ailleurs, le matériau diélectrique peut, dans certains modes de réalisation, être déposé en une seule étape et recouvrir ainsi les zones de transparence, Le matériau diélectrique est donc avantageusement transparent ou semi-transparent à la lumière visible afin de ne pas réduire la transmission de la lumière à travers les dites zones de transparence. En outre, l'indice de réfraction du matériau diélectrique est avantageusement compris entre l'indice de réfraction du substrat transparent ou de l'électrode transparente et celui de l'air ou d'une colle optique transparente, de manière à réduire les phénomènes optiques de réflexions aux interfaces et d'augmenter la transmission de la lumière au niveau des zones de transparence.
Suivant différents modes de réalisation, le substrat transparent peut être constitué d'un matériau solide tel que le verre minéral, le verre organique ou encore un polymère de type PMMA, PET ou polycarbonate, et peut être rigide ou flexible.
Dans un mode de réalisation particulier non représenté, le substrat transparent est recouvert d'une surface fonctionnelle, par exemple antireflet ou anti-UV,
L'invention a également pour objet tout appareil utilisant une ou plusieurs mono cellules décrites ici.
Un autre objet de l'invention concerne le procédé de fabrication d'une telle mono cellule photovoltaïque semi-transparente, tel que défini dans la revendication 23, dans lequel procédé :
- on approvisionne une mono cellule semi-transparente à la lumière comportant une pluralité de zones actives photovoltaïques séparées par des zones de transparence :
- on aménage des canaux dans les zones actives photovoltaïques par gravure ou ablation des matériaux constitutifs de l'électrode métallique et de la couche d'absorbeur ;
- on dépose un matériau diélectrique autour des zones actives photovoltaïques non gravées tout en laissant apparente une zone de l'électrode transparente au niveau des canaux ;
- on dépose une grille de collecte ainsi que les bus de collecte de la face avant et de la face arrière,

### Figures

L'invention sera mieux comprise à l'aide de sa description détaillée, en relation avec les figures, dans lesquelles :
- la figure 1 est une vue en coupe transversale de deux cellules photovoltaïques adjacentes connectées en série dans un module photovoltaïque multicellulaire classique, tel que décrit dans le document EP0500451-B1 faisant partie de l'état de la technique ;
- la figure 2 est une vue schématique de dessus d'un module photovoltaïque connu de la figure 1 ;
- la figure 3 est une vue schématique de détail du module selon la figure 1 et la figure 2, à savoir une vue en coupe transversale de la zone de connexion E entre deux cellules adjacentes du module photovoltaïque ;
- la figure 4 est une vue schématique en plan d'un module photovoltaïque multicellulaire et semi transparent selon l'état de la technique;
- la figure 5 est une vue en plan d'une mono cellule photovoltaïque représentée avant la réalisation de zones de transparence ;
- la figure 6 est une vue en plan de la mono celllule photovoltaïque selon la figure 5, pourvu de ses zones de transparence ;
- la figure 7 est une vue en plan de la mono cellule photovoltaïque de la figure 6, pourvu en outre d'une grille de collecte ;
   les figures 8 à 11 sont des vues en coupe transversale montrant quatre modes de réalisation de la grille de collecte de la mono cellule photovoltaïque;
- les figures 12 à 15 sont des vues en coupe transversale d'autres modes de réalisation, dans lesquels la grille de collecte est enterrée soit dans la couche de l'électrode transparente de la mono cellule photovoltaïque, soit dans la couche d'absorbeur.
- La figure 16 est une vue en coupe transversale d'un mode de réalisation utilisant un autre type de diode photovoltaïque avec un empilement de couches minces différent de ceux des figures 8 à 15.
- les figures 17a, 17b et 17c illustrent respectivement une vue de face et deux vues en coupe transversale d'une autre mono cellule photovoltaïque selon l'invention.
- les figures 18a, 18b, 18c et 18d montrent schématiquement en coupe transversale des objets qui illustrent différentes étapes intermédiaires d'un procédé de fabrication de la mono cellule photovoltaïque représentée sur les figures 17a à 17c.

Les figures ne sont pas à l'échelle, les épaisseurs relatives des composants de la mono cellule étant volontairement exagérées pour mieux faire apparaître sa structure,

### Description détaillée

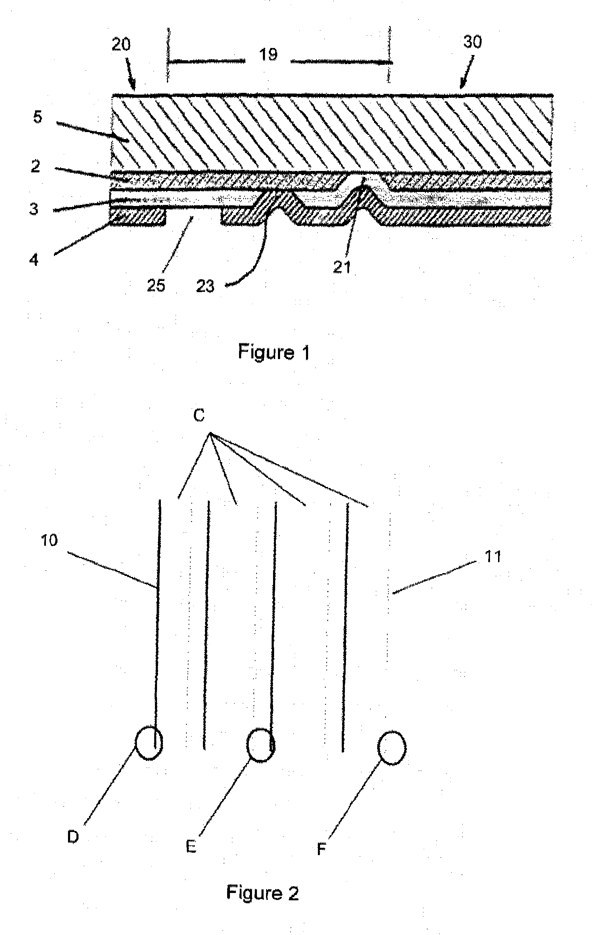

On se réfère à la figure 1, qui est une reproduction de la figure 7 du document de brevet EP0500451-B1 mentionné précédemment. Les références numériques de cette figure sont telles qu'elles apparaissent dans ledit document. Le module photovoltaïque comporte deux cellules photovoltaïques adjacentes 20, 30 reliées entre elles par une zone d'interconnexion 19 constituée de trois zones parallèles et sensiblement adjacentes : une zone 21 d'interruption de l'électrode transparente 2, qui correspond à la gravure dite P1, où la couche d'absorbeur photovoltaïque 3 d'une cellule vient directement au contact du substrat 5 ; une zone de percement ou d'interruption 23 qui correspond à la gravure dite P2 de cette même couche semi-conductrice, où l'électrode métallique 4 vient directement au contact de l'électrode transparente 2 de la cellule voisine 20, puis une autre zone d'interruption 25 de l'électrode métallique, qui correspond à la gravure dite P3.
La semi-transparence de ce module connu est assurée par des bandes transparentes perpendiculaires aux zones d'interconnexion série 19, découpées par gravure, puis reconnectées entre elles par des reprises de contact.

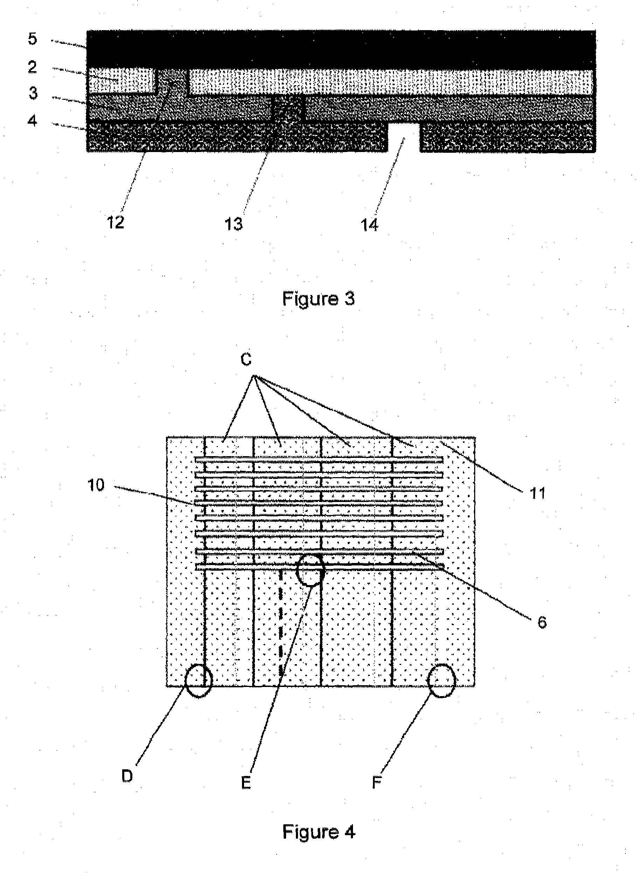

On a représenté en figure 3 une vue plus schématique de cette structure connue de la figure 1, avec des références numériques qui seront reprises dans la suite de la description. La structure est composée d'un substrat en verre référencé **5,** et d'un empilement de couches minces (**2,3,4**). L'indice **2** représente une couche conductrice transparente, constituant l'électrode transparente. L'indice **3** représente la couche d'absorbeur photovoltaïque, typiquement en silicium dopé, comme connu en soi. L'indice **4** représente une couche conductrice, typiquement métallique. constituant l'électrode métallique.
En **12** on a représenté une ligne d'isolation de l'électrode transparente **2.** Elle est obtenue par la gravure **P1** et permet d'isoler électriquement les électrodes avant de deux cellules adjacentes. En **13** on a représenté la ligne d'isolation de l'absorbeur. Elle est obtenue par la gravure **P2** et permet d'isoler électriquement les absorbeurs de deux cellules adjacentes. En **14** on a représenté la ligne d'isolation de l'électrode métallique **4.** Elle est obtenue par la gravure **P3** et permet d'isoler électriquement les électrodes métalliques de deux cellules adjacentes.

On a représenté en figure 2 une vue schématique en plan d'un module photovoltaïque selon la figurg 3. Les différentes lignes de gravure correspondant aux gravures **P1, P2** et **P3** sont visibles, à des degrés divers, en fonction de la profondeur à laquelle elles sont réalisées par rapport à la surface du substrat. Ainsi, la référence **10** indique les bus de connexion, l'un des bus étant connecté à l'anode et l'autre à la cathode, La référence C indique plusieurs cellules photovoltaïques mises en série. D E et F indiquent les traces de découpe laser ou chimique qui sont visibles du dessus par transparence, et qui correspondent respectivement aux lignes de gravure réalisées dans les différentes couches.
Les zones les plus visibles dans la réalité sont constituées par les gravures correspondant aux zones **E** de la figure 3, qui correspondent aux zones de mise en série de cellules photovoltaïques élémentaires. Mais on voit également les gravures **D,F** correspondant aux bus de connexion des anodes et des cathodes du module.
Ce qui se voit le plus dans la zone **E** de mise en série de cellules élémentaires, c'est le contact métallique **13** (figure 3) qui correspond à la mise en série de deux cellules voisines (métal sur couche transparente conductrice).
On voit également la ligne **12** correspondant à la gravure de l'électrode transparente **2,** à cause du saut d'indice dans l'empilement, puisqu'on passe directement d'un indice de 1,5 du substrat **5** en verre, à un indice de 3,5 pour le silicium de l'absorbeur 3, de ce fait la réflexion lumineuse sur la ligne de gravure **12** sera plus forte et visible.
Pour la ligne d'isolation **14** de l'électrode métallique **4,** il y a une rupture dans la continuité optique, puisque le trou dans le métal opaque de l'électrode métallique 4 laisse passer la lumière résiduelle non guidée par le système optique du module, dans le cas où le module photovoltaïque utilise un tel système optique pour guider la lumière,

La figure 4 est une vue similaire à celle de la figure 2, mais on y a ajouté des zones de transparence 6, réalisées ici sous la forme de bandes de transparence découpées, par exemple par gravure laser, dans les couches d'électrodes et d'absorbeur.
La présence des bandes de transparence laisse subsister la visibilité des plans de gravure **P1, P2, P3** comme expliqué plus haut, mais on voit maintenant des lignes de gravure en trait interrompu. L'ensemble de ces traces de gravure **(12,13,14)** de la zone de mise en série E est visible et perturbe la qualité de vision d'une image qui serait disposée sous le module photovoltaïque, de sorte que ce type de module connu ne peut pas être valablement intégré dans un dispositif électronique du type téléphone portable, car l'incidence négative de ces traces sur la visibilité de l'image sur l'écran serait trop néfaste.

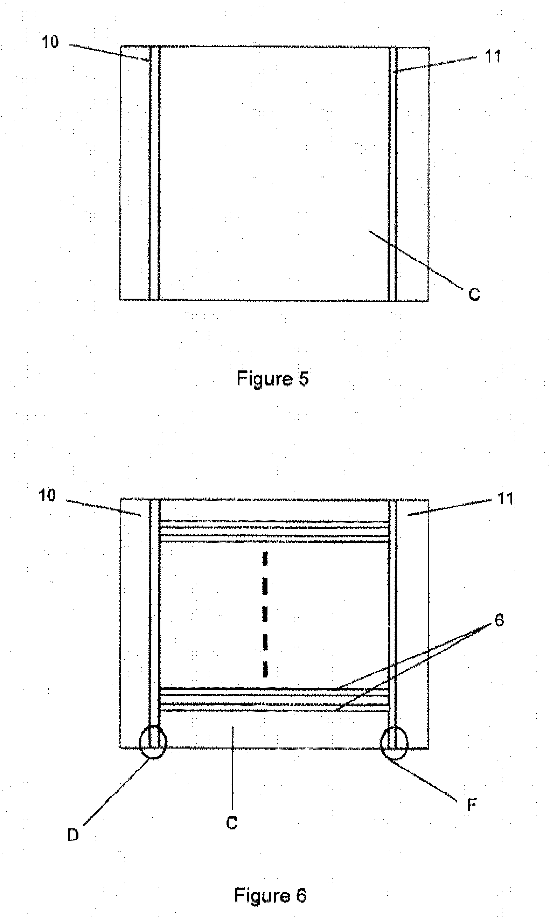

On se réfère maintenant aux figures 5 et 6 pour décrire le principe de l'invention faisant appel à une cellule photovoltaïque unique, dite mono cellule, susceptible de couvrir toute la surface utile d'un dispositif, par exemple l'écran d'un dispositif électronique d'affichage, comme par exemple un téléphone portable.
En figure 5 on a représenté une mono cellule en vue de dessus, avant la réalisation des zones de transparence **6.** Comme on le voit, la réalisation consiste en une seule cellule photovoltaïque unique et d'un seul tenant C. Elle est délimitée sur ses côtés par des bus de connexion **(10,11),** qui sont en contact avec l'électrode transparente **2** pour l'un et avec l'électrode métallique **4** pour l'autre, et dont on aperçoit en vue en plan les rayures de gravure laser **D,F** (figure 6) Dans cette configuration, à la différence des modules photovoltaïques connus décrits en référence aux figures 1 à 4, il n'y a plus aucune zone de connexion pour la mise en série de cellules multiples, puisqu'il n'y a plus qu'une seule cellule photovoltaïque de grande taille, à la place d'une multitude de petites cellules élémentaires connectées en série.

En figure 6 on a représenté la même vue en plan de la mono cellule photovoltaïque de la figure 5, mais après réalisation dans la cellule, typiquement opaque, d'un ensemble de zones de transparence **6**. Ces zones de transparence **6** sont par exemple réalisées par découpe de bandes régulières, notamment à l'aide d'un procédé de gravure par faisceau laser. Les zones ou bandes de transparence **6** sont de préférence régulièrement espacées. Pour une image dont l'observateur est proche, les bandes de transparence et/ou les bandes actives photovoltaïques sont typiquement espacées d'une distance inférieure à une centaine de micromètres. Pour une image dont l'observateur est plus éloigné, les bandes de transparence et/ou les bandes actives photovoltaïques sont de préférence espacées d'une distance inférieure au millimètre,

Selon un mode de réalisation avantageux de la mono cellule photovoltaïque certaines zones de transparence **6** peuvent être remplacées, à intervalles de préférence réguliers, par une grille de collecte **8** conductrice, comme représenté en vue en plan en figure 7, et en vue en coupe en figure 8. Elle est beaucoup plus conductrice que le matériau constitutif de l'électrode transparente **2** et permet de réduire la résistance série de ladite électrode transparente **2.** La grille de collecte **8** fonctionne comme un shunt électrique placé sur l'électrode transparente **2.** Elle est réalisée par exemple en aluminium, en silicium dopé n ou p, en argent ou autre matière très conductrice de l'électricité.

Comme on le voit sur la figure 8, la grille de collecte **8** est positionnée sur l'électrode transparente après enlèvement de la couche d'absorbeur **3** qui s'y trouvait. Entre la grille de collecte **8** et les zones d'absorbeur **3** adjacentes se trouvent les zones de transparence **6,** qui correspondent aux zones dans lesquelles la couche d'absorbeur **3** et celle de l'électrode métallique **4** ont été enlevées, notamment par gravure laser, gravure chimique ou gravure plasma. Les zones de collecte de courant sont constituées par le reste des empilements de zones d'absorbeur et des restes d'électrode métallique qui les surmontent.

En liaison avec les figures subséquentes, on va décrire plusieurs variantes possibles pour la réalisation d'une telle grille de collecte **8**.

En figure 8, l'Interface entre la grille de collecte **8** et l'électrode transparente **2,** qui est métallique et brillante, peut être visible par l'observateur en vue de dessus, ce qui peut nuire à l'aspect visuel du dispositif dans lequel le module photovoltaïque est susceptible d'être incorporé. Une façon de résoudre ce problème consiste à interposer entre la grille de collecte **8** et l'électrode transparente **2,** un élément non réfléchissant (non représenté).

Une autre solution consiste à minimiser la taille visible de la grille dé collecte **8,** comme représenté en figure 9, dans laquelle la grille de collecte **8** possède une forme de T renversé, de sorte que la base du T soit située à l'interface avec l'électrode transparente **2.** Ainsi, la surface métallique de la grille de collecte **8** qui est visible en vue de dessus, est réduite, bien que le volume de la grille de collecte **8,** et donc sa capacité de conduction électrique, soit inchangée par rapport à la figure 8.

La figure 10 représente encore une autre variante de réalisation de la grille de collecte 8, dans laquelle l'optimisation optique de la visibilité de la grille de collecte est obtenue par un autre moyen. Plutôt que de créer une grille de collecte assez large à la place de certaines bandes d'absorbeur **3,** on réalise une grille de collecte **8** plus fine sur l'électrode transparente **2,** au droit de chacune des couches d'absorbeur photovoltaïque **3.** Bien entendu, l'homme du métier saura adapter la densité des lignes de grille de collecte **8** en fonction de la résistance électrique intrinsèque de l'electrode transparente **2** et en fonction du courant électrique que la cellule photovoltaïque doit fournir dans l'application visée.

Une autre variante, de grille de collecte **8** est représentée en figure 11. Cette structure présente des zones actives photovoltaïques **1** réalisées dans une cellule photovoltaïque, et reposant sur un substrat transparent **5.** Les zones actives photovoltaïques **1** sont composées d'une électrode transparente **2,** d'une couche d'absorbeur **3** et d'une électrode métallique **4.** Un matériau diélectrique **9** (oxyde, nitrure, polymère...) enrobe les couches (**3,4**) à la manière d'un capot, sur toute la longueur des bandes actives photovoltaïques **1.** Un matériau conducteur, idéalement métallique (cuivre, aluminium, argent...), est déposé au-dessus du matériau diélectrique **9,** également sur toute la longueur des bandes **1.** Il existe ainsi un contact électrique entre le matériau métallique 8 et l'électrode transparente **2** de la cellule photovoltaïque, Il n'existe cependant aucun contact électrique entre ce même matériau métallique **8** et les autres couches (**3,4**) qui composent la cellule photovoltaïque. Dans cette variante, le matériau **8** joue le rôle d'une grille de collecte métallique **8** qui collecte les électrons circulant dans l'électrode transparente **2** de la cellule photovoltaïque. Cette structure présente l'avantage de diminuer la résistance électrique série de la cellule grâce à la réduction du chemin électrique parcouru par les électrons dans l'électrode transparente **2,** composée d'un matériau transparent conducteur généralement plus résistif. La couche **8** peut également jouer le rôle d'un réflecteur de lumière qui augmente l'efficacité énergétique de la cellule. Il est à noter que l'électrode transparente **2** peut être commune à toutes les bandes actives photovoltaïques **1.** On obtient alors une électrode transparente **2** mutualisée pour l'ensemble des bandes actives photovoltaïques **1.**
Une autre façon de procéder consiste à réaliser une grille de collecte non plus disposée en relief sur l'électrode transparente de l'électrode transparente, mais d'enterrer la grille de collecte à l'intérieur de l'électrode transparente de l'électrode transparente, comme représenté dans les variantes des figures 12 à 15.
En figure 12, une grille de collecte 8 est enterrée dans l'électrode transparente 2 entre deux bandes actives photovoltaïques adjacentes. Mais compte tenu de la transparence du substrat en verre **5** et de l'électrode transparente **2,** si la grille de collecte **8** est un peu trop large, il se peut que son reflet métallique soit encore visible en transparence à travers le verre et le matériau conducteur transparent qui le recouvre. On peut atténuer cela en interposant une couche antireflets (non représentée) entre le verre et la grille de collecte **8.**

Une autre variante représentée en figure 14 consiste à réaliser la grille de collecte **8** sous la forme d'un ensemble de fines lignes conductrices **8,** chaque ligne ayant une largeur inférieure à la largeur de la zone de collecte constituée par l'empilement **(3,4),** et étant disposée dans l'électrode transparente **2,** en regard d'une ligne correspondante d'absorbeur **3.** Comme l'absorbeur **3** et la grille de collecte **8** ont une brillance semblable, la grille de collecte n'ajoutera pas de perturbation visuelle supplémentaire . En outre, les lignes d'absorbeur **3** seront très peu visibles, du fait qu'elles constituent un réseau de lignes régulièrement espacées.

Bien que la ligne conductrice formée par la grille de collecte **8** créera une perte de surface de collecte photovoltaïque en comparaison avec une solution sans grille de collecte **8,** la perte sera dans certains cas suffisamment faible pour que cela soit intéressant par rapport à la perte induite par le matériau conducteur transparent. En effet, à faible illumination (∼1000 lux), l'influence de la résistance électrique série sur la puissance générée n'est pas notable, donc l'intérêt de la grille de collecte est faible voire nul. En revanche, dans le cas d'une forte illumination (∼0,5 SUN soit environ 50 000 lux), la résistance série de l'électrode transparente **2** est fortement pénalisante (soit une perte de puissance de l'ordre de 50%). Ainsi la grille de collecte fait perdre une petite partie de la surface active photovoltaïque soit par ombrage, soit par diminution de la surface active, mais en revanche elle permet d'exploiter tout le potentiel de la diode photovoltaïque. Donc, à forte illumination la grille de collecte 8 fait en définitive gagner de la puissance électrique produite.
Un autre avantage de cette variante est que l'on garde un approvisionnement standard du matériau absorbeur et qu'il n'y a pas besoin de graver l'électrode transparente. De plus l'électrode transparente peut être très fine (de l'ordre de quelques dizaines de nanomètres), ce qui permet de conserver une grande transparence du module entre les zones de collecte.

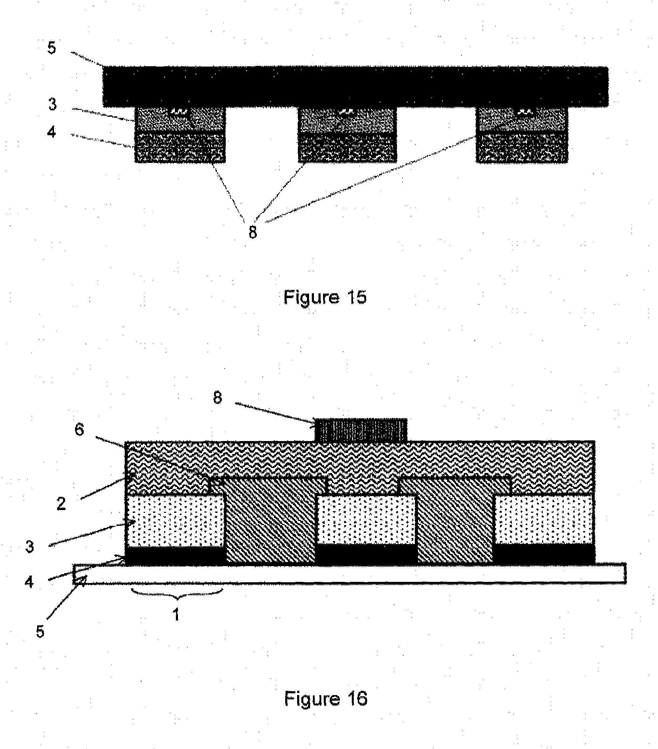

Il est à noter que les variantes à grille de collecte **8** enterrée dans l'électrode transparente **2** ont des avantages supplémentaires du point de vue du rendement de fabrication. En effet, lorsque la grille de collecte **8** est intercalée sous l'électrode transparente et entre les bandes d'absorbeur comme représenté en figures 8 à 11, elle est réalisée en dernière étape. Or il s'agit d'une étape ayant un taux de perte très élevée pouvant aller jusqu'à 90% de déchet Pour limiter les pertes il est possible de réaliser la grille de collecte **8** soit directement sur le substrat en verre avant le dépôt des couches constituant l'absorbeur (figures 12,14), soit même à l'intérieur de l'électrode transparente **2** (figure 13), ou même sans électrode transparente (figure 15).

La première option semble être la plus économiquement intéressante. En effet, si, lors de la réalisation de la grille de collecte **8** des défauts de fabrication apparaissent, il est très simple de retravailler les plaques à très faible coût. De plus la grille de collecte enterrée offre une grande plage de procédés de fabrication possibles pour la réalisation de la prise de contact métallique de la grille de collecte **8** sur l'électrode transparente **2,** notamment en ce qui concerne les gammes de températures, sans risque de détérioration des couches d'absorbeur **3** puisque celles-ci ne sont pas encore déposées lors de la réalisation de la prise de contact grille de collecte/électrode transparente.

La figure 15 est similaire à la figure 14, mais on y a enlevé l'électrode transparente : les bandes de collecte **8** sont suffisamment fines pour que la conductivité de l'absorbeur **3** suffise à collecter les électrons directement vers la grille de collecte 8, sans l'aide d'un matériau conducteur transparent.

En figure 16, on a représenté une structure qui est une variante de celles des figures 8. 14 ou 15, dans laquelle la mono cellule comporte un absorbeur **3** qui est un matériau de type CIGS (Cuivre, Indium, Gallium, Sélénium). L'empilement des couches minces **(2,3,4)** est alors inversé et forme une jonction P-N. Dans ce cas il est nécessaire d'interposer un isolant électrique transparent 6, encore appelé diélectrique transparent, entre les zones actives photovoltaïques **1.** Mais cela montre en particulier que l'invention, utilisant une mono cellule photovoltaïque, peut aisément être adaptée à différents matériaux absorbeurs, et est en définitive indépendante de la technique de capture de photons utilisée.
On se réfère maintenant à la figure 17, qui illustre une vue de face d'une autre mono cellule photovoltaïque selon l'invention (figure 17a) et deux coupes transversales de ladite mono cellule vues selon l'axe J (figure 17b) ou selon l'axe K (figure 17c), les deux axes étant définis à la figure 17a.
La mono cellule est composée de trois bandes actives photovoltaïques **1,** elles-mêmes constituées de trois couches minces, à savoir une électrode transparente **2,** une couche d'absorbeur **3** et une électrode métallique **4.** Ces bandes actives photovoltaïques **1** sont séparées par des bandes libres **6** correspondant à des zones de transparence au niveau desquelles la couche d'absorbeur **3** et l'électrode métallique **4** ont été gravées. Les bandes actives photovoltaïques **1** contiennent une pluralité de canaux **7** qui sont également des ouvertures aménagées dans ces bandes actives photovoltaïques **1** par gravure de la couche d'absorbeur **3** et de l'électrode métallique 4.
Ces canaux **7** permettent de mettre en contact électrique l'électrode transparente **2** avec une grille de collecte 8, électriquement conductrice, de manière à réduire la résistance intrinsèque de l'électrode transparente **2** tout en minimisant la visibilité de cette grille **6.** Toutefois, afin de ne pas réduire les performances électriques de la mono cellule, la grille de collecte 8 est séparée de l'électrode métallique **4** et de la couche d'absorbeur **3** des bandes actives photovoltaïques **1** par un matériau diélectrique **9.** L'ensemble des grilles de collecte **8** situées sur chaque bande active photovoltaïque **1** est relié en périphérie de la mono cellule à un bus de collecte de la face avant **10** qui permet de collecter les charges électriques transportées jusqu'à l'électrode transparente **2.** A l'opposé de ce bus de collecte de la face avant **10,** on retrouve un bus de collecte de la face arrière **11** qui permet de relier les électrodes métalliques **4** de chaque bande active photovoltaïque **1** et de collecter ainsi les charges transportées jusqu'auxdites électrodes métalliques **4.**

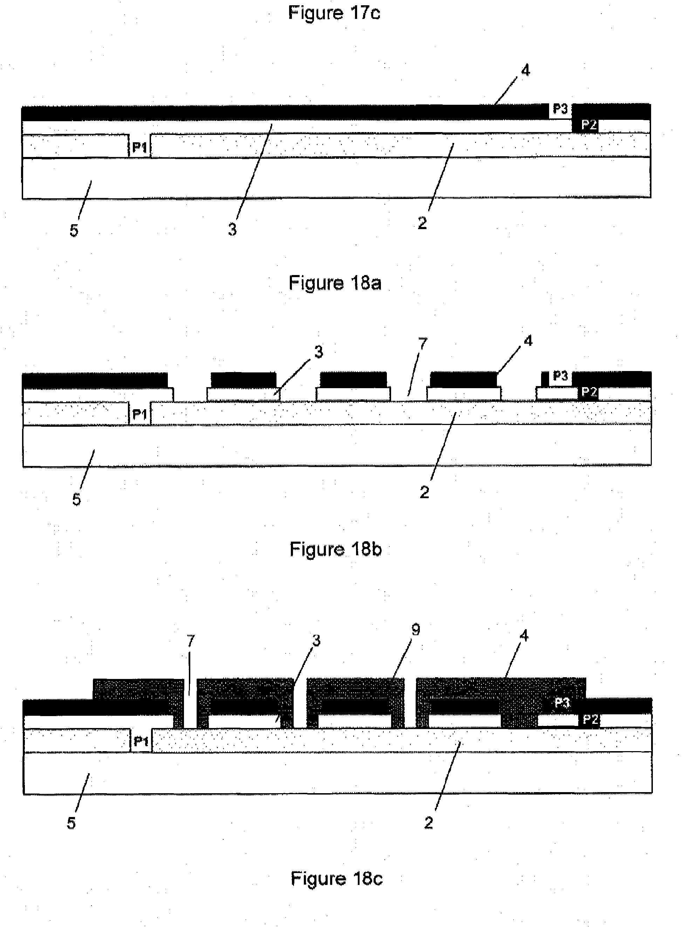

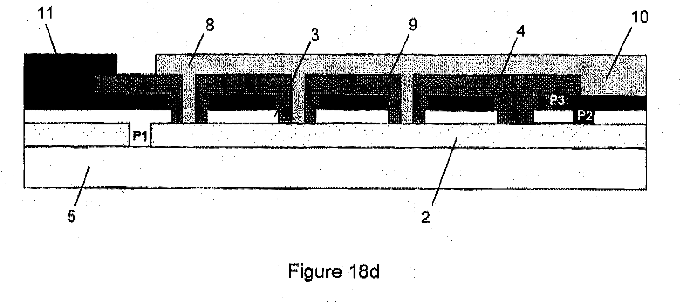

La figure 18 montre schématiquement en coupe transversale des objets qui illustrent différentes étapes d'un procédé selon l'invention, les vues en coupe étant réalisées au niveau des bandes actives photovoltaïques 1, selon l'axe L défini à la figure 17a.

Dans une première étape (figure 18a), on approvisionne une mono cellule semi-transparente à la lumière comportant une pluralité de zones actives photovoltaïques **1** séparées par des zones de transparence **6.** Les zones actives photovoltaïques **1** comportent à leur périphérie, au niveau des zones de connexions électriques, plusieurs zones d'interruption des couches minces **(2,3,4),** généralement parallèles :
- une première zone d'interruption de l'électrode transparente **2,** qui correspond à la gravure dite **P1,** où la couche d'absorbeur **3** vient directement au contact du substrat **5:**
- une deuxième zone d'interruption de la couche d'absorbeur **3,** qui correspond à la gravure dite **P2,** où l'électrode arrière **4** vient directement au contact de l'électrode avant **2** ;
- une troisième zone d'interruption de l'électrode arrière **4,** qui correspond à la gravure dite **P3.**

Dans une deuxième étape (figure 18b), on aménage des canaux **7** dans les zones actives photovoltaïques **1** par gravures successives des matériaux constitutifs de l'électrode métallique **4** et de la couche d'absorbeur 3. Ces gravures peuvent être réalisées par voie humide ou sèche à l'aide d'un procédé de photo-lithographie, de nano-impression (en anglais «nano-imprint») ou bien directement par ablation laser. Les étapes de photo-lithographie et de nano-impression (non représentées sur la figure) sont connues de l'homme du métier et consistent à déposer une résine non permanente, photosensible ou thermosensible selon un motif prédéfini avant gravure, puis à dissoudre ladite résine en fin de procédé. Les gravures peuvent être réalisées à l'aide d'une solution adaptée pour dissoudre les matériaux des couches **3** et **4,** ou à l'aide d'un plasma ou encore par laser.

Dans une troisième étape (figure 18c), on dépose un matériau diélectrique **9** autour des zones actives photovoltaïques non gravées tout en laissant apparente une zone de l'électrode transparente **2** au niveau des canaux **7.** Le procédé utilisé dans cette étape est typiquement un procédé de photolithographie, dans lequel le matériau diélectrique **9** est une résine permanente, de préférence transparente, développée selon le motif souhaité.

Enfin, la dernière étape (figure 18d) consiste à déposer la grille de collecte 8, ainsi que les bus de collecte **(10,11)** de la face avant et de la face arrière pour obtenir la mono cellule photovoltaïque semi-transparente selon l'invention. Le dépôt d'un matériau conducteur électriquement, comme un métal, peut être réalisé sur toute la mono cellule de manière à combler les zones précédemment gravées, avant d'isoler électriquement par photolithographie et gravure, le bus de collecte de la face arrière 11 de la grille de collecte 8 et de dégager les zones de transparence (figure 18a).

### Avantages de l'invention

La mono cellule photovoltaïque selon l'invention permet d'atteindre les buts visés. Grâce à sa conception, il n'y a plus de gravure de mise en série dans la zone active, ni de problème d'ombrage d'une cellule élémentaire, ni de perte de surface liée aux gravures de mise en série.

La cellule photovoltaïque selon l'invention permet donc d'obtenir à la fois une bonne homogénéité optique, une performance électrique améliorée, et une surface utile de production optimale.

Les techniques de fabrication d'une telle cellule restent standard, par dépôt de couches, lithographie et gravure, sur du matériel standard.

### Liste des repères utilisés sur les figures

| | | | |
|---|---|---|---|
| 1 | Zone active photovoltaïque | 10 | Bus de collecte de la face avant |
| 2 | Electrode transparente | 11 | Bus de collecte de la face arrière |
| 3 | Couche d'absorbeur | 12 | Ligne de gravure de l'électrode transparente (gravure P1) |
| 4 | Electrode métallique | 13 | Ligne de gravure de l'absorbeur (gravure P2) |
| 5 | Substrat transparent | 14 | Ligne de gravure de l'électrode métallique (gravure P3) |
| 6 | Zone de transparence | 20,30 | Cellules photovoltaïques adjacentes |
| 7 | Canal | 21 | Zone d'interruption de l'électrode transparente (gravure P1) |
| 8 | Grille de collecte | 23 | Zone d'interruption de l'absorbeur (gravure P2) |
| 9 | Matériau diélectrique | 25 | Zone d'interruption de l'électrode métallique (gravure P3) |

## Revendications

1. Mono cellule photovoltaïque semi-transparente à la lumière comportant une pluralité de zones actives photovoltaïques (1) séparées par des zones de transparence (6),
- lesdites zones actives photovoltaïques (1) étant formées d'un empilement de couches minces (2, 3, 4) constituées au moins d'une électrode transparente (2), d'une couche d'absorbeur (3) et d'une électrode métallique (4) disposées sur un substrat (5) transparent à la lumière;
- et lesdites zones de transparence (6) étant des ouvertures aménagées au moins dans l'électrode métallique (4) et dans la couche d'absorbeur (3) pour laisser passer un maximum de lumière;
**caractérisée en ce qu'**elle comporte en outre une grille de collecte (8) électriquement conductrice disposée au contact de l'électrode transparente (2) pour réduire sa résistance électrique et **en ce que** lesdites zones actives photovoltaïques (1) contiennent en outre plusieurs canaux (7), aménagés dans l'électrode métallique (4) et la couche d'absorbeur (3), au niveau desquels ladite grille de collecte (8) est en contact avec l'électrode transparente (2), ladite grille de collecte (8) étant séparée de l'électrode métallique (4) et de la couche d'absorbeur (3) par un matériau diélectrique (9), de manière à réduire la résistance série de l'électrode transparente (2) tout en minimisant la visibilité de la grille de collecte (8).

2. Mono cellule photovoltaïque selon la revendication 1, **caractérisée en ce que** lesdites zones de transparence (6) sont réalisées par des ouvertures en forme de bandes rectilignes, discontinues ou non, ou selon d'autres formes quelconques, ladite grille de collecte (8) étant alors de taille et de forme adaptées auxdites ouvertures pour limiter sa visibilité au niveau des zones de transparence (6).

3. Mono cellule photovoltaïque selon l'une des revendications précédentes, **caractérisée en ce que** certaines zones actives photovoltaïques (1) sont substituées par une grille de collecte (8) disposée sur l'électrode transparente (2) entre deux zones actives photovoltaïques adjacentes (1.1'), l'ensemble des grilles de collecte (8) étant reliées électriquement par un bus de collecte (10).

4. Mono cellule photovoltaïque selon l'une des revendications précédentes, **caractérisée en ce que**, pour minimiser l'impact visuel de la grille de collecte (8), ladite grille de collecte a la forme d'un T renversé disposé sur certaines zones actives photovoltaïques (1), de façon que seule une petite surface de la grille de collecte (8) correspondant à la base du T renversé n'entre en contact avec l'électrode transparente (2).

5. Mono cellule photovoltaïque selon l'une des revendications 1 et 2, **caractérisée en ce que** les zones actives photovoltaïques (1) sont constituées de couches d'absorbeur (3) et d'électrodes métalliques (4) moins larges que les électrodes transparentes (2), et **en ce que** la grille de collecte (8) est constituée de fines bandelettes métalliques disposées sur l'électrode transparente (2) situées au droit de la couche d'absorbeur (3).

6. Mono cellule photovoltaïque selon l'une des revendications 1 et 2, **caractérisée en ce que** la grille de collecte (8) est réalisée sous la forme de capots métalliques disposés sur un matériau diélectrique (9) entourant les zones actives photovoltaïques (1) formées d'un empilement de couches minces (2, 3, 4).

7. Mono cellule photovoltaïque selon l'une des revendications 1 et 2, **caractérisée en ce que** la grille de collecte (8) est disposée sur le substrat (5) avant la réalisation de l'électrode transparente (2), de sorte que ladite grille de collecte (8) se trouve enterrée dans l'électrode transparente (2).

8. Mono cellule photovoltaïque selon la revendication 7, **caractérisée en ce qu'**elle comporte une couche d'antireflet interposée entre le substrat (5) et la grille de collecte (8) enterrée.

9. Mono cellule photovoltaïque selon l'une des revendications 7 ou 8, **caractérisée en ce que** tes zones de la grille de collecte (8) sont disposées dans te couche d'électrode transparente (2), sous tes zones actives photovoltaïques (1) et en retrait par rapport à l'interface avec te substrat (5), et ont une largeur inférieure à la largeur des zones actives photovoltaïques (1), de sorte que la grille de collecta (8) limite l'ombrage de te lumière ambiante pour maximiser te génération de courant par tes zones actives photovoltaïques (1).

10. Mono cellule photovoltaïque selon l'une des revendications 1 et 2, **caractérisée en ce que** la grille de collecte (8) est disposée directement à l'intérieur de la couche d'absorbeur (3).

11. Mono cellule photovoltaïque selon l'une des revendications précédentes, **caractérisée en ce que** ladite grille de collecte (8) est métallique.

12. Mono cellule photovoltaïque selon l'une des revendications précédentes, **caractérisée en ce que** lesdites grilles de collecte (8) sont reliées électriquement entre elles par un bus de collecte de la face avant (10) isolé électriquement d'un bus de collecte de la face arrière (11) qui relie les électrodes métalliques (4).

13. Mono cellule photovoltaïque selon l'une des revendications 1 ou 6, **caractérisée en ce que** ledit matériau diélectrique (9) est transparent ou semi-transparent à la lumière visible.

14. Mono cellule photovoltaïque selon l'une des revendications 1, 6 ou 13, **caractérisée en ce que** l'indice de réfraction du matériau diélectrique (9) est avantageusement compris entre l'indice de réfraction du substrat transparent (5) ou de l'électrode transparente (2) et celui de l'air ou d'une colle optique transparente.

15. Mono cellule photovoltaïque selon l'une des revendications précédentes, **caractérisée en ce que** lesdites zones actives photovoltaïques (1) sont de formes quelconques et de dimensions telles que l'œil humain ne les distingue pas.

16. Mono cellule photovoltaïque selon l'une des revendications précédentes, **caractérisée en ce que** lesdites zones actives photovoltaïques (1) ou les zones de transparence (6) sont organisées en réseaux de structures géométriques élémentaires, linéaires, circulaires ou polygonales.

17. Mono cellule photovoltaïque selon l'une des revendications précédentes, **caractérisée en ce que** ladite électrode transparente (2) est constituée de graphène ou de nanostructures métalliques ou encore d'un oxyde conducteur transparent tel que le SnO₂, l'ITO, l'IZO, l'AZO, le BZO, le GZO ou I'ZnO.

18. Mono cellule photovoltaïque selon l'une des revendications précédentes, **caractérisée en ce que** ladite couche d'absorbeur (3) est constituée d'un ou plusieurs matériaux semi-conducteurs inorganiques et/ou organiques, par exemple à base de silicium amorphe ou microcristallin. de GaAs (arséniure de gallium), de CdTe (tellurure de cadmium), de CIGS (cuivre - indium - gallium - sélénium) ou à base de polymères.

19. Mono cellule photovoltaïque selon l'une des revendications précédentes, **caractérisée en ce que** ladite électrode métallique (4) est constituée d'un métal tel que l'aluminium (Al), le nickel (Ni), l'or (Au), l'argent (Ag), le cuivre (Cu). le molybdène (Mo), le chrome (Cr), le titane (Ti) ou le palladium (Pd).

20. Mono cellule photovoltaïque selon l'une des revendications précédentes, **caractérisée en ce que** le substrat transparent (5) peut être constitué d'un matériau solide tel que le verre minéral, le verre organique ou encore un polymère de type PMMA, PET ou polycarbonate, et peut être rigide ou flexible.

21. Mono cellule photovoltaïque selon l'une des revendications précédentes, **caractérisée en ce que** le substrat transparent (5) est recouvert d'une surface fonctionnelle, par exemple antireflet ou anti-UV.

22. Appareil électrique, **caractérisé en ce qu'**il comporte une ou plusieurs mono cellules selon l'une quelconque des revendications précédentes,

23. Procédé de fabrication d'une mono cellule photovoltaïque selon la revendication 1, dans lequel procédé
- on approvisionne une mono cellule semi-transparente à la lumière comportant une pluralité de zones actives photovoltaïques (1) séparées par des zones de transparence (6);
- on aménage des canaux (7) dans les zones actives photovoltaïques (1) par gravure ou ablation des matériaux constitutifs de l'électrode métallique (4) et de la couche d'absorbeur (3);
- on dépose un matériau diélectrique (9) autour des zones actives photovoltaïques (1) non gravées tout en laissant apparente une zone de l'électrode transparente (2) au niveau des canaux (7);
- on dépose une grille de collecte (8) ainsi que les bus de collecte de la face avant (10) et de la face arrière (11).

## Patentansprüche

1. Für Licht halb durchlässige fotovoltaische Monozelle, die eine Vielzahl aktiver fotovoltaischer Zonen (1) umfasst, die von Durchlässigkeitszonen (6) getrennt sind,
- wobei die aktiven fotovoltaischen Zonen (1) aus einer Stapelung von dünnen Schichten (2, 3, 4) gebildet sind, die zumindest aus einer durchlässigen Elektrode (2), einer Absorberschicht (3) und einer metallischen Elektrode (4) bestehen, die auf einem für Licht durchlässigen Substrat (5) angeordnet sind,
- und die Durchlässigkeitszonen (6) Öffnungen sind, die zumindest in der metallischen Elektrode (4) und in der Absorberschicht (3) eingerichtet sind, um ein Maximum an Licht durchzulassen;
**dadurch gekennzeichnet, dass** sie außerdem ein elektrisch leitendes Sammelgitter (8) umfasst, das in Kontakt mit der durchlässigen Elektrode (2) angeordnet ist, um ihren elektrischen Widerstand zu verringern, und dass die aktiven fotovoltaischen Zonen (1) außerdem mehrere Kanäle (7) enthalten, die in der metallischen Elektrode (4) und der Absorberschicht (3) eingerichtet sind, und in deren Bereich das Sammelgitter (8) mit der durchlässigen Elektrode (2) in Kontakt ist, wobei das Sammelgitter (8) von der metallischen Elektrode (4) und der Absorberschicht (3) durch ein dielektrisches Material (9) in der Weise getrennt ist, dass der Serienwiderstand der durchlässigen Elektrode (2) reduziert wird, während gleichzeitig die Sichtbarkeit des Sammelgitters (8) minimiert wird.

2. Fotovoltaische Monozelle nach Anspruch 1, **dadurch gekennzeichnet, dass** die Durchlässigkeitszonen (6) durch Öffnungen in Form geradliniger Streifen, die diskontinuierlich sind oder nicht, oder gemäß anderen beliebigen Formen hergestellt sind, wobei das Sammelgitter (8) eine Größe und eine Form aufweist, die an die Öffnungen angepasst sind, um seine Sichtbarkeit in dem Bereich der Durchlässigkeitszonen (6) einzuschränken.

3. Fotovoltaische Monozelle nach einem der vorstehenden Ansprüche, **dadurch gekennzeichnet, dass** bestimmte aktive fotovoltaische Zonen (1) durch ein Sammelgitter (8) ersetzt sind, das auf der durchlässigen Elektrode (2) zwischen zwei aneinandergrenzenden aktiven fotovoltaischer Zonen (1.1') angeordnet ist, wobei die Einheit der Sammelgitter (8) durch einen Sammelbus (10) elektrisch verbunden ist.

4. Fotovoltaische Monozelle nach einem der vorstehenden Ansprüche, **dadurch gekennzeichnet, dass** zum Minimieren der visuellen Auswirkung des Sammelgitters (8) das Sammelgitter die Form eines umgekehrten T aufweist, das auf bestimmten aktiven fotovoltaischer Zonen (1) derart angeordnet ist, dass nur eine kleine Oberfläche des Sammelgitters (8), die der Basis des umgekehrten T entspricht, mit der durchlässigen Elektrode (2) in Kontakt tritt.

5. Fotovoltaische Monozelle nach einem der Ansprüche 1 und 2, **dadurch gekennzeichnet, dass** die aktiven fotovoltaischen Zonen (1) aus Absorberschichten (3) und metallischen Elektroden (4) gebildet sind, die weniger breit sind als die durchlässigen Elektroden (2), und dass das Sammelgitter (8) aus feinen Metallstreifchen gebildet ist, die auf der durchlässigen Elektrode (2) angeordnet sind und die im rechten Winkel zu der Absorberschicht (3) liegen.

6. Fotovoltaische Monozelle nach einem der Ansprüche 1 und 2, **dadurch gekennzeichnet, dass** das Sammelgitter (8) in der Form von Metallhauben ausgebildet ist, die auf einem dielektrischen Material (9) angeordnet sind, das die aktiven fotovoltaischen Zonen (1) umgibt, die aus einer Stapelung von Dünnschichten (2, 3, 4) gebildet sind.

7. Fotovoltaische Monozelle nach einem der Ansprüche 1 und 2, **dadurch gekennzeichnet, dass** das Sammelgitter (8) auf dem Substrat (5) vor der Herstellung der durchlässigen Elektrode (2) derart angeordnet wird, dass das Sammelgitter (8) in der durchlässigen Elektrode (2) eingelassen ist.

8. Fotovoltaische Monozelle nach Anspruch 7, **dadurch gekennzeichnet, dass** sie eine reflexfreie Schicht umfasst, die zwischen dem Substrat (5) und dem eingelassenen Sammelgitter (8) eingefügt ist.

9. Fotovoltaische Monozelle nach einem der Ansprüche 7 oder 8, **dadurch gekennzeichnet, dass** die Zonen des Sammelgitters (8) in der Schicht durchlässiger Elektrode (2) unter den aktiven fotovoltaischer Zonen (1) und im Rücksprung in Bezug auf eine Schnittfläche mit dem Substrat (5) angeordnet sind, und eine Breite aufweisen, die kleiner ist als die Breite der aktiven fotovoltaischen Zonen (1), so dass das Sammelgitter (8) die Beschattung des Umgebungslichts einschränkt, um das Erzeugen von Strom durch die aktiven fotovoltaischen Zonen (1) zu maximieren.

10. Fotovoltaische Monozelle nach einem der Ansprüche 1 und 2, **dadurch gekennzeichnet, dass** das Sammelgitter (8) direkt in dem Inneren der Absorberschicht (3) angeordnet ist.

11. Fotovoltaische Monozelle nach einem der vorstehenden Ansprüche, **dadurch gekennzeichnet, dass** das Sammelgitter (8) metallisch ist.

12. Fotovoltaische Monozelle nach einem der vorstehenden Ansprüche, **dadurch gekennzeichnet, dass** die Sammelgitter (8) miteinander durch einen Sammelbus der Vorderseite (10), der von einem Sammelbus der Rückseite (11), der die metallischen Elektroden (4) verbindet, elektrisch isoliert ist, verbunden sind.

13. Fotovoltaische Monozelle nach einem der Ansprüche 1 oder 6, **dadurch gekennzeichnet, dass** das dielektrische Material (9) für sichtbares Licht durchlässig oder halb durchlässig ist.

14. Fotovoltaische Monozelle nach einem der Ansprüche 1, 6 oder 13, **dadurch gekennzeichnet, dass** der Brechungsindex des dielektrischen Materials (9) vorteilhafterweise zwischen dem Brechungsindex des durchlässigen Substrats (5) oder der durchlässigen Elektrode (2) und dem von Luft oder eines durchlässigen optischen Klebstoffs liegt.

15. Fotovoltaische Monozelle nach einem der vorstehenden Ansprüche, **dadurch gekennzeichnet, dass** die aktiven fotovoltaischen Zonen (1) beliebig geformt sind und Maße derart aufweisen, dass das menschliche Auge sie nicht erkennt.

16. Fotovoltaische Monozelle nach einem der vorstehenden Ansprüche, **dadurch gekennzeichnet, dass** die aktiven fotovoltaischen Zonen (1) oder die Durchlässigkeitszonen (6) in Netzen aus elementaren, linearen, kreisförmigen oder vieleckigen geometrischen Strukturen organisiert sind.

17. Fotovoltaische Monozelle nach einem der vorstehenden Ansprüche, **dadurch gekennzeichnet, dass** die durchlässige Elektrode (2) aus Grafen oder metallischen Nanostrukturen oder auch einem durchlässigen leitenden Oxid wie SnO₂, ITO, IZO, AZO, BZO, GZO oder ZnO besteht.

18. Fotovoltaische Monozelle nach einem der vorstehenden Ansprüche, **dadurch gekennzeichnet, dass** die Absorberschicht (3) aus einem oder mehreren anorganischen und/oder organischen Halbleitermaterialien, zum Beispiel auf der Basis amorphen oder mikrokristallinen Siliziums, oder GaAs (Galliumarsenid), CdTe (Cadmiumtellurid), CIGS (Kupfer - Indium - Gallium - Selenium) oder auf der Basis von Polymeren gebildet ist.

19. Fotovoltaische Monozelle nach einem der vorstehenden Ansprüche, **dadurch gekennzeichnet, dass** die metallische Elektrode (4) aus einem Metall wie Aluminium (Al), Nickel (Ni), Gold (Au), Silber (Ag), Kupfer (Cu), Molybdän (Mo), Chrom (Cr), Titan (Ti) oder Palladium (Pd) gebildet ist.

20. Fotovoltaische Monozelle nach einem der vorstehenden Ansprüche, **dadurch gekennzeichnet, dass** das durchlässige Substrat (5) aus einem festen Material wie Mineralglas, organischem Glas oder auch einem Polymer vom Typ PMMA, PET oder Polycarbonat gebildet ist, und starr oder biegsam sein kann.

21. Fotovoltaische Monozelle nach einem der vorstehenden Ansprüche, **dadurch gekennzeichnet, dass** das durchlässige Substrat (5) mit einer funktionalen, zum Beispiel einer reflexfreien oder UV-Schutz-Oberfläche bedeckt ist.

22. Elektrogerät, **dadurch gekennzeichnet, dass** es eine oder mehrere Monozellen nach einem der vorstehenden Ansprüche umfasst.

23. Verfahren zur Herstellung einer fotovoltaischen Monozelle nach Anspruch 1, wobei bei dem Verfahren
- eine für Licht halb durchlässige fotovoltaische Monozelle bereitgestellt wird, die eine Vielzahl aktiver fotovoltaischer Zonen (1) umfasst, die von Durchlässigkeitszonen (6) getrennt sind;
- Kanäle (7) in den aktiven fotovoltaischer Zonen (1) durch Gravur oder Abtragen der Materialien, die die metallische Elektrode (4) und die Absorberschicht (3) bilden, eingerichtet werden;
- ein dielektrisches Material (9) um die aktiven fotovoltaischen Zonen (1), die nicht graviert sind, angeordnet wird, während eine Zone der durchlässigen Elektrode (2) in dem Bereich der Kanäle (7) sichtbar gelassen wird;
- ein Sammelgitter (8) sowie der Sammelbus der Vorderseite (10) und der Rückseite (11) angeordnet werden.

## Claims

1. A photovoltaic mono cell semi-transparent to light, comprising a plurality of photovoltaic active zones (1) separated by transparency zones (6),
- said photovoltaic active zones (1) being formed by a stack of thin layers (2, 3, 4) constituted at least by a transparent electrode (2), an absorber layer (3) and a metallic electrode (4) which are arranged on a substrate (5) transparent to light;
- and said transparency zones (6) being openings arranged at least in the metallic electrode (4) and in the absorber layer (3) to allow a maximum of light to pass;
**characterized in that** it further comprises an electrically conductive collection grid (8) arranged in contact with the transparent electrode (2) to reduce its electrical resistance and **in that** said photovoltaic active zones (1) further contain several channels (7), arranged in the metallic electrode (4) and the absorber layer (3), at the level of which said collection grid (8) is in contact with the transparent electrode (2), said collection grid (8) being separated from the metallic electrode (4) and the absorber layer (3) by a dielectric material (9), so as to reduce the series resistance of the transparent electrode (2) while minimizing the visibility of the collection grid (8).

2. The photovoltaic mono cell according to Claim 1, **characterized in that** said transparency zones (6) are formed by openings in the form of discontinuous or non-discontinuous rectilinear bands, or according to any other shapes, said collection grid (8) being thus of a size and shape adapted to said openings so as to limit its visibility at the level of the transparency zones (6).

3. The photovoltaic mono cell according to one of the preceding claims, **characterized in that** certain photovoltaic active zones (1) are substituted by a collection grid (8) arranged on the transparent electrode (2) between two adjacent photovoltaic active zones (1.1'), the set of collection grids (8) being connected electrically by a collection bus (10).

4. The photovoltaic mono cell according to one of the preceding claims, **characterized in that**, to minimize the visual impact of the collection grid (8), said collection grid has the shape of an inverted T arranged on certain photovoltaic active zones (1), in such a way that only a small area of the collection grid (8) corresponding to the base of the inverted T comes into contact with the transparent electrode (2).

5. The photovoltaic mono cell according to one of Claims 1 and 2, **characterized in that** the photovoltaic active zones (1) are constituted by absorber layers (3) and by metallic electrodes (4) that are less wide than the transparent electrodes (2), and **in that** the collection grid (8) is constituted by fine metallic strips arranged on the transparent electrode (2) and situated at right angles to the absorber layer (3).

6. The photovoltaic mono cell according to one of Claims 1 and 2, **characterized in that** the collection grid (8) is made in the form of metallic caps arranged on a dielectric material (9) surrounding the photovoltaic active zones (1) formed of a stack of thin layers (2, 3, 4).

7. The photovoltaic mono cell according to one of Claims 1 and 2, **characterized in that** the collection grid (8) is arranged on the substrate (5) before the production of the transparent electrode (2), so that said collection grid (8) is situated buried in the transparent electrode (2).

8. The photovoltaic mono cell according to Claim 7, **characterized in that** it comprises an antireflection layer interposed between the substrate (5) and the buried collection grid (8).

9. The photovoltaic mono cell according to one of Claims 7 or 8, **characterized in that** the zones of the collection grid (8) are arranged in the transparent electrode layer (2), under the photovoltaic active zones (1) and set back with respect to the interface with the substrate (5), and have a smaller width than the width of the photovoltaic active zones (1), so that the collection grid (8) limits the shadowing of the ambient light so as to maximize the generation of current by the photovoltaic active zones (1).

10. The photovoltaic mono cell according to one of Claims 1 and 2, **characterized in that** the collection grid (8) is arranged directly in the interior of the absorber layer (3).

11. The photovoltaic mono cell according to one of the preceding claims, **characterized in that** said collection grid (8) is metallic.

12. The photovoltaic mono cell according to one of the preceding claims, **characterized in that** said collection grids (8) are connected electrically with one another by a collection bus of the front face (10) which is insulated electrically from a collection bus of the rear face (11) which connects the metallic electrodes (4).

13. The photovoltaic mono cell according to one of Claims 1 or 6, **characterized in that** said dielectric material (9) is transparent or semi-transparent to visible light.

14. The photovoltaic mono cell according to one of Claims 1, 6 or 13, **characterized in that** the refractive index of the dielectric material (9) is advantageously comprised between the refractive index of the transparent substrate (5) or of the transparent electrode (2) and that of the air or of a transparent optical glue.

15. The photovoltaic mono cell according to one of the preceding claims, **characterized in that** said photovoltaic active zones (1) are of any shapes and dimensions such that the human eye does not distinguish them.

16. The photovoltaic mono cell according to one of the preceding claims, **characterized in that** said photovoltaic active zones (1) or the transparency zones (6) are organized into networks of linear, circular or polygonal elementary geometric structures.

17. The photovoltaic mono cell according to one of the preceding claims, **characterized in that** said transparent electrode (2) is constituted by graphene or by metallic nanostructures or else by a transparent conducting oxide such as SnO₂, ITO, IZO, AZO, BZO, GZO or ZnO.

18. The photovoltaic mono cell according to one of the preceding claims, **characterized in that** said absorber layer (3) is constituted by one or more inorganic and/or organic semi-conducting materials, for example based on amorphous or microcrystalline silicon, GaAs (gallium arsenide), CdTe (cadmium telluride), CIGS (copper - indium - gallium - selenium) or based on polymers.

19. The photovoltaic mono cell according to one of the preceding claims, **characterized in that** said metallic electrode (4) is constituted by a metal such as aluminium (Al), nickel (Ni), gold (Au), silver (Ag), copper (Cu), molybdenum (Mo), chromium (Cr), titanium (Ti) or palladium (Pd).

20. The photovoltaic mono cell according to one of the preceding claims, **characterized in that** the transparent substrate (5) can be constituted by a solid material such as mineral glass, organic glass or else a polymer of the PMMA, PET or polycarbonate type, and can be rigid or flexible.

21. The photovoltaic mono cell according to one of the preceding claims, **characterized in that** the transparent substrate (5) is covered by a functional surface, for example antireflective or anti-UV.

22. An electrical apparatus, **characterized in that** it comprises one or more mono cells according to any one of the preceding claims.

23. A method for the manufacture of a photovoltaic mono cell according to Claim 1, in which method
- a mono cell, semi-transparent to light, is provided, comprising a plurality of photovoltaic active zones (1) separated by transparency zones (6) ;
- channels (7) are arranged in the photovoltaic active zones (1) by etching or ablation of the constituent materials of the metallic electrode (4) and of the absorber layer (3);
- a dielectric material (9) is deposited around non-etched photovoltaic active zones (1) while leaving visible a zone of the transparent electric (2) at the level of the channels (7);
- a collection grid (8) and the collection buses of the front face (10) and of the rear face (11) are deposited.
